# EUROPÄISCHE PATENTSCHRIFT

(11) **EP 2 837 756 B1**
(45) Veröffentlichungstag und Bekanntmachung des Hinweises auf die Patenterteilung: **21.02.2018**
(21) Anmeldenummer: 14002430.8
(22) Anmeldetag: 15.07.2014
(51) Int. Cl.: E05B 17/22, E05B 47/00, H01H 27/06, H03K 17/96, H03K 17/945, E05B 65/10

(54) **Schlüsseltaster mit Berührungssensor**
Key-operated button with touch sensor
Bouton à clé doté d'un capteur tactile

(30) Priorität: 30.07.2013 DE 102013108144
(43) Veröffentlichungstag der Anmeldung: 18.02.2015
(73) Patentinhaber: dormakaba Deutschland GmbH, 58256 Ennepetal (DE)
(72) Erfinder: Gehrmann, Bernd, D-44805 Bochum (DE)
(74) Vertreter: Balder IP Law, S.L.

(56) Entgegenhaltungen:
- WO-A1-03/074823
- DE-A1- 2 045 339
- DE-A1- 4 411 290
- DE-A1- 10 359 848
- DE-A1- 19 539 729
- DE-A1-102008 029 698

## Beschreibung

Die vorliegende Erfindung betrifft einen Schlüsseltaster zur Sicherung von Türen, Toren oder Fenstern, umfassend einen Montagerahmen, einen Schließzylinder und eine den Montagerahmen abdeckende Blende, die zumindest an dem Montagerahmen befestigbar ist.

Derartige Schlüsseltaster werden insbesondere benutzt, um bestimmten Personen den Zugang oder das Verlassen von Gebäuden, Räumen oder Bereichen über gesicherte Türen zu ermöglichen. Diese Personen sind mit einem Hilfsmittel, wie beispielsweise einem Schlüssel oder einer Codekarte ausgestattet, welche den Zugang durch eine Tür oder ein Tor freischalten. Neben der Verwendung im öffentlichen Bereich, wie beispielsweise in industriellen Anlagen oder in öffentlichen Gebäuden, werden solche Schlüsseltaster auch im privaten Bereich zum Öffnen und Schließen von Tür- und Toranlagen benutzt, die von außen bedienbar und gegen Fremdzugang gesichert sein sollen. Die Schrift DE 20 45 339 A1 offenbart ein elektrisches Schaltschloss für Türen mit einem Montageraum, einem Schließzylinder und einer Blende. Ferner offenbart die Schrift DE 20 45 339 A1 einen Drucktaster, der zwischen Montageraum und Blende angeordnet ist.

Um den Versuch eines Fremdzugangs anzuzeigen, ist innerhalb eines Gehäuses der bekannten Schlüsseltaster ein Sabotageschalter verbaut. Kommt es zu einer Manipulation des Gehäuses wird dabei über den Sabotageschalter eine Sabotagemeldung abgesetzt, beispielsweise in Form eines akustischen Warnsignals.
Es sind auch Schlüsseltaster bekannt, die zur Fluchttürsteuerung vorzugsweise im Rahmen einer Türmanagement-System-Fluchtwegsicherung (TMS-Fluchtwegsicherung), ausgebildet sind. Dabei sind die Schlüsseltaster so ausgestaltet, dass diese auch außerhalb einer Fluchtgefahr von Innen aus einem Raum, einem Gebäude oder einem Bereich aktivierbar sind, um beispielsweise den Raum, das Gebäude oder die Bereiche durch eine gesicherte Fluchttür verlassen zu können. Die Aktivierung der bekannten Schlüsseltaster ist dabei nur über mitgeführte Hilfsmittel möglich. Führt eine Person diese Hilfsmittel nicht mit sich, kann eine gesicherte Fluchttür nicht ohne eine Manipulation oder Zerstörung des Schlüsseltasters und insbesondere der im Gehäuse befindlichen Steuerung passiert werden, wenn sich diese Tür im Verriegelungsmodus befindet. Eine Manipulation oder Zerstörung des Schlüsseltasters und insbesondere des Gehäuses löst dabei durch den im Gehäuse eingebauten Sabotageschalter einen Sabotagealarm, beispielsweise in Form eines akustischen Signals aus.

Davon ausgehend liegt der vorliegenden Erfindung die Aufgabe zugrunde, einen Schlüsseltaster zu schaffen, dessen Funktionsweise in einem System einer Fluchtwegsicherung gewährleistet ist, und der zumindest zeitweise aktivierbar ist, um eine Entriegelung beispielsweise einer Fluchttür auch ohne von Personen mitgeführten Hilfsmitteln zu erlauben.

Diese Aufgabe wird gemäß dem Oberbegriff des Anspruchs 1 in Verbindung mit den kennzeichnenden Merkmalen gelöst. Vorteilhafte Weiterbildungen sind in den abhängigen Ansprüchen angegeben.

Die Erfindung schließt die technische Lehre ein, dass im Bereich zwischen dem Montagerahmen und der Blende wenigstens ein Berührungssensor angeordnet ist, über den der Schlüsseltaster betätigbar ist.
Erfindungsgemäß umfasst der Schlüsseltaster einen Berührungssensor. Dabei ist der Sensor im Bereich zwischen dem Montagerahmen und der Blende angeordnet, dass heißt dass der Sensor hinter der Blende liegt. Dabei ist der Sensor so sensitiv, d. h. so berührungsempfindlich eingestellt, dass bereits ein Annähern an den Sensor zu einer Betätigung des Schlüsseltasters führt, der dann eine Kurzzeitentriegelung oder eine andere parametrierbare Funktionen, wie beispielsweise eine Langzeitentriegelung, einer Tür, eines Tores oder eines Fensters auslöst. Um den Schlüsseltaster über den Berührungssensor betätigen zu können, muss dieser unter Beibehaltung der Fluchtwegsicherung zumindest zeitweise aktivierbar sein. Hierzu kann der Berührungssensor beispielsweise über eine programmierte Steuerung oder über eine interne Zeitschaltuhr in einen aktiven Modus und einen inaktiven Modus geschaltet werden. Will man beispielsweise einen Fluchtweg tagsüber sichern, diesen aber ungehindert aus einem Raum, Gebäude oder Bereich von innen nach außen passieren können, wird der Berührungssensor des erfindungsgemäßen Schlüsseltasters aktiviert, dass heißt in einen aktiven Modus, beispielsweise in einen Tagmodus geschaltet. Dadurch ist die Fluchtwegsicherung weiterhin gesichert bzw. aktiv. Die Sicherung kann aber bei Berührung oder Annäherung, beispielsweise einer Hand einer Person an den Schlüsseltaster, über den aktiven Berührungssensor kurzzeitig überwunden werden. Dadurch kann vorzugsweise eine Kurzzeitentriegelung einer Tür, eines Tores oder eines Fensters ausgelöst werden, und der Fluchtweg kann passiert werden. Ist der Berührungssensor dagegen in einen inaktiven Modus geschaltet, beispielsweise in einen Nachtmodus, ist die Fluchtwegsicherung nach wie vor aktiv und kann auch nicht durch Berührung oder Annäherung einer Hand einer Person an den Berührungssensor überwunden werden. Ein Passieren des Fluchtweges ist dadurch ohne Hilfsmittel, wie beispielsweise einem Schlüssel, mit dem der Schlüsseltaster aktivierbar ist, nicht möglich.

In vorteilhafter Weise ist der erfindungsgemäße Schlüsseltaster mit dem Berührungssensor mit bereits bekannten Türmanagementsystemen kompatibel. Ein solches als Fluchtwegsicherung eingesetztes System ist beispielsweise von der Firma Dorma mit der Bezeichnung TMS-Fluchtwegsicherung bekannt.

Vorteilhafterweise ist der Berührungssensor an dem Montagerahmen angeordnet und durch eine Blende abgedeckt. Der Montagerahmen und die Blende, die mit einer Unter- oder Aufputzdose das Gehäuse des erfindungsgemäßen Schlüsseltasters bilden, entsprechen in vorteilhafter Weise den Dimensionen der Standardaufputz- oder Unterputzsysteme, die aus Kunststoff oder Metall bestehen. Eine Steuerung, die innerhalb des Gehäuses angeordnet ist, wird dabei über den Montagerahmen auf oder in einer Wand befestigt, vorzugsweise über Schraubverbindungen.

In ganz bevorzugter Weise ist der Montagerahmen integral mit dem Berührungssensor ausgebildet. Die integrale Ausgestaltung bedeutet, dass der Montagerahmen als Berührungssensor ausgebildet ist. Dadurch kommen dem als Berührungssensor ausgestalteten Montagerahmen mehre Funktionen zu. Zum einen dient der Montagerahmen weiterhin zur Befestigung der Steuerung auf oder in einer Wand und zum anderen dient der Montagerahmen als berührungssensitives Bauteil des Schlüsseltasters, über welches beispielsweise eine Kurzzeitentriegelung oder eine andere parametierbare Funktion, wie beispielsweise eine Langzeitentriegelung, der Fluchtwegsicherung bewirkt wird. Zudem kann der Berührungssensor zur Sabotageüberwachung dienen, nämlich dadurch, dass bei Manipulation an dem Schlüsseltaster, beispielsweise eine versuchte Manipulation an der in dem Gehäuse angeordneten Steuerung, über den als Berührungssensor ausgestalteten Montagerahmen gemeldet werden kann. Dies erfolgt dadurch, dass zur Manipulation der Steuerung, die sich im Gehäuse des Schlüsseltasters befindet, der Montagerahmen, über den die Steuerung an oder in einer Wand befestigt ist, zuvor entfernt werden muss. Das Lösen des Montagerahmens von oder aus der Wand kann dabei nicht kontaktlos erfolgen. Wird daher der Montagerahmen beim Lösen von oder aus der Wand über eine gewisse Zeitdauer berührt, also ein dadurch erzeugtes Berührungssignal des als Berührungssensor ausgestalteten Montagerahmens über eine längere Zeitdauer ansteht, kann automatisch ein Signal erzeugt werden, dass der Vorwarnung bzw. der Anzeige eines Sabotageaktes an dem Schlüsseltaster dient. Steht beispielsweise ein Berührungssignal vom Berührungssensor länger als 10 Sekunden an, kann vorzugsweise vor der Meldung eines Sabotageaktes eine beispielsweise akustische Vorwarnung aktiviert werden, die solange andauert, bis der Berührungssensor kein Signal mehr abgibt. Durch ein abstellbares Vorwarnsignal, welches fälschlicherweise ausgelöst wurde, kann dabei wirkungsvoll ein falscher Sabotagealarm unterbunden werden. Wird jedoch ein Zeitlimit für die Berührung des als Montagerahmen ausgestalteten Berührungssensors überschritten, welches beispielsweise 20 Sekunden betragen kann, wird ein Signal für einen Sabotageakt vom Schlüsseltaster abgesetzt. Die genannten Zeiten sind beispielhaft zu verstehen, da diese je nach Anwendungsbereich vorzugsweise parametrierbar sind.

Das Vorwarnsignal kann neben einem akustischen Signal auch ein visualisiertes Signal sein. Vorzugsweise handelt es sich dabei um ein Signal, welches über einen DCW Bus gesendet und über eine Parametrierungssoftware, die beispielsweise unter dem Begriff TMS Soft der Firma Dorma bekannt ist, visualisiert werden.

Vorzugsweise ist die Steuerung, beispielsweise als Platinensteuerung, im Gehäuse des Schlüsselschalters angeordnet. Das bedeutet in vorteilhafter Weise, dass für eine Manipulation der Steuerung ein Zugang zu dem Gehäuse geschaffen werden muss, wozu die Blende, die am Montagerahmen befestigt ist, zuvor entfernt werden müsste. Da jedoch der Berührungssensor vorteilhaft über einen Sabotagekontakt mit der Blende gekoppelt ist, würde bei der Zerstörung oder der Entfernung der Blende vom Montagerahmen ein dadurch ausgelöstes Sabotagesignal bereits Auskunft über die Manipulation am Schlüsseltaster geben. Eine Fremdmanipulation der Steuerung im Gehäuse des Schlüsseltasters kann dadurch wirkungsvoll verhindert werden.

Die Steuerung des Schlüsseltasters steht in vorteilhafter Weise in Datenaustausch mit einer übergeordneten Steuerung, die zum einen zur Zeitprogrammierung des Schlüsseltasters dienen kann und die zum anderen Signale vom Schlüsseltaster empfängt. In besonders bevorzugter Weise erfolgt der Datenaustausch mit der übergeordneten Steuerung über den DCW-Bus. Dabei kann der DCW-Bus beispielsweise Signale vom Schlüsseltaster an die übergeordnete Steuerung senden bzw. Signale von der übergeordneten Steuerung an den Schlüsseltaster senden. Vorteilhafterweise können die über den DCW-Bus vom Schlüsselschalter gesendeten Signale mittels einer Software verarbeitet und können beispielsweise über die Software TMS Soft der Firma Dorma in akustische Signale gewandelt oder visualisiert werden.

Wird, wie bereits beschrieben, der Berührungssensor länger als 10 Sekunden aktiviert, kann automatisch ein akustisches Vorwarnsignal aktiviert werden, das solange andauert, bis der Berührungssensor kein Signal mehr abgibt. Dies geschieht bevorzugt durch die Bewegung der Hand der Person aus dem Erfassungsbereich des berührungsempfindlichen Sensors. Alternativ kann aber auch das Vorwarnsignal beispielsweise manuell mittels eines Schlüssels am Schlüsseltaster durch Rechts- oder Linkstastung deaktiviert wird. Natürlich kann das Vorwarnsignal auch über die Systemsoftware abgeschaltet werden. Dauert eine Aktivierung des Berührungssensors länger als beispielsweise 20 Sekunden an, führt dies in vorteilhafter Weise zu einem Sabotagealarm. Wird demnach beispielsweise versucht, den Schlüsseltaster mechanisch zu manipulieren, was ohne eine Entfernung der Blende nicht möglich ist, sendet der Schlüsseltaster über den mit der Blende gekoppelten Montagerahmen, der als Berührungssensor ausgestaltet ist, ein Signal in Form eines Sabotagealarms über den DCW-Bus an die übergeordnete Steuerung. Eine Entkopplung des Montagerahmens mit der Blende, vorzugsweise eine Entkopplung des Montagerahmens und der Blende über eine Unterbrechung oder Zerstörung eines Sabotagekontaktes zwischen Blende und Montagerahmen, führt demnach automatisch zu einer Meldung eines Sabotagealarms. Dies geschieht vorzugsweise über ein auf der Rückseite der Blende ausgebildetes Kontaktelement, beispielsweise in Form eines Kunststoffblocks, welches den auf der Platinensteuerung angeordneten Sabotagekontakt beim Aufbringen der Blende auf den Montagerahmen durch in Eingriffbringung oder durch mechanische Belastung in eine Kontaktstellung bringt. Wird die Blende vom Montagerahmen entfernt, wird der Sabotagekontakt außer Eingriff mit dem Kontaktelement gebracht, bzw. der Sabotagekontakt mechanisch entlastet. Dadurch öffnet der Sabotagekontakt aus seiner Kontaktstellung, worauf beispielsweise ein Sabotagealarm über den erfindungsgemäßen Schlüsseltaster abgesetzt wird.

Da die mechanische Manipulation des Schlüsseltasters und eine Manipulation der hinter dem Montagerahmen des Schlüsseltasters liegenden Platinensteuerung durch den als Berührungssensor ausgestalteten Montagerahmen als Sabotageakt erkannt wird, lässt sich der erfindungsgemäße Schlüsseltaster auch zur Sabotageüberwachung einsetzen.

Als übergeordnete Steuerung kann beispielsweise die zentrale Steuerung und Überwachung in einer Leitstelle oder Zentrale verstanden werden. Die Leitstelle oder Zentrale kann dabei in oder außerhalb eines zu sichernden und zu überwachenden Gebäudes liegen.

In vorteilhafter Weise wird die Funktion des Berührungssensors am Schlüsseltaster durch eine Statusanzeige angezeigt. Natürlich kann die Statusanzeige auch über die Software in der Leitstelle oder der Zentrale angezeigt werden. Bei der Statusanzeige am Schlüsseltaster handelt es sich in bevorzugter Weise um eine Anzeige, die wenigstens ein Leuchtmittel umfasst. Als Leuchtmittel sind in bevorzugter Weise Leuchtdioden (LED) zu nennen. Demnach kann es sich bei der Statusanzeige um eine LED-Anzeige handeln. Beispielsweise könnte die Funktion des Berührungssensors, also dessen Aktivierung, durch eine blaue LED angezeigt werden. Natürlich könnte auch die Deaktivierung des Berührungssensors durch eine andersfarbige LED angezeigt werden. Natürlich könnte es sich bei der LED auch um eine mehrfarbige LED handeln, die in unterschiedlichen Farben die Aktivierung oder Deaktivierung des Berührungssensors anzeigt. Es ist auch denkbar, dass die LED-Anzeige durch frequentiertes An- und Ausschalten den Status des Berührungssensors angibt. Beispielsweise könnte ein frequentiertes An- und Ausschalten als Vorwarnsignal bei einer Aktivierung des Berührungssensors von mehr als 10 Sekunden dienen.

In vorteilhafter Weise erfolgt die Kopplung der Blende mit dem Montagerahmen und der Platinensteuerung über wenigstens einen Sabotagekontakt. Wird wie bereits beschrieben der Sabotagekontakt beispielsweise bei mechanischer Manipulation an der Blende zwischen der Blende und dem als Berührungssensor ausgestalteten Montagerahmen unterbrochen, d. h. das an der Rückseite der Blende ausgestaltete Kontaktelement außer Kontakt mit dem auf der Platinsteuerung angeordneten Sabotagekontakt gebracht, bzw. der Sabotagekontakt zerstört, sendet der Schlüsseltaster über den DCW-Bus ein Signal und dieses kann beispielsweise über die TMS Soft als "Vorwarnung Sabo" oder sofort als Sabotagealarm ohne eine vorherige Vorwarnung eines Sabotagealarms visualisiert bzw. akustisch angezeigt werden.

In vorteilhafter Weise ist der Berührungssensor an einem bekannten Schlüsseltaster angeordnet. Das heißt, dass die Funktion des Berührungssensors eine zusätzliche Funktion zu den Funktionen der bekannten Schlüsseltaster ist. Es ist aber auch denkbar, dass über den Berührungssensor insbesondere in Verbindung mit beispielsweise der TMS Soft Funktionen der bekannten Schlüsseltaster ersetzt werden kann. So könnte beispielsweise eine Verriegelung der Tür bereits durch eine Deaktivierung des Berührungssensors oder durch einen "Verriegelungsbefehl" über die TMS Soft an die Steuerung des Tasters erfolgen. Demzufolge ist es durch die Anordnung eines Berührungssensors am Montagerahmen oder durch die Ausgestaltung des Montagerahmens als Berührungssensor auch denkbar, einen Taster ohne einen Schließzylinder zur Sicherung von Türen, Toren oder Fenstern bereitzustellen.

### BEVORZUGTE AUSFÜHRUNGSBEISPIELE DER ERFINDUNG

Weitere, die Erfindung verbessernde Maßnahmen werden nachstehend mit der Beschreibung bevorzugter Ausführungsbeispiele der Erfindung anhand der Figuren näher dargestellt. Es zeigt:
- Fig. 1: einen Schlüsseltaster in einer Draufsicht mit Darstellung der elektrischen Bauteile, des Schließzylinders und des als Berührungssensor ausgebildeten Montagerahmens,
- Fig. 2: eine Blende in einer Draufsicht für den Schlüsseltaster gemäß Figur 1 und
- Fig. 3: einen Schaltplan der Steuerung für den Berührungssensor des Schlüsseltasters gemäß der Figur 1.

In den unterschiedlichen Figuren sind gleiche Teile stets mit denselben Bezugszeichen versehen, weshalb diese in der Regel auch nur einmal beschrieben werden.

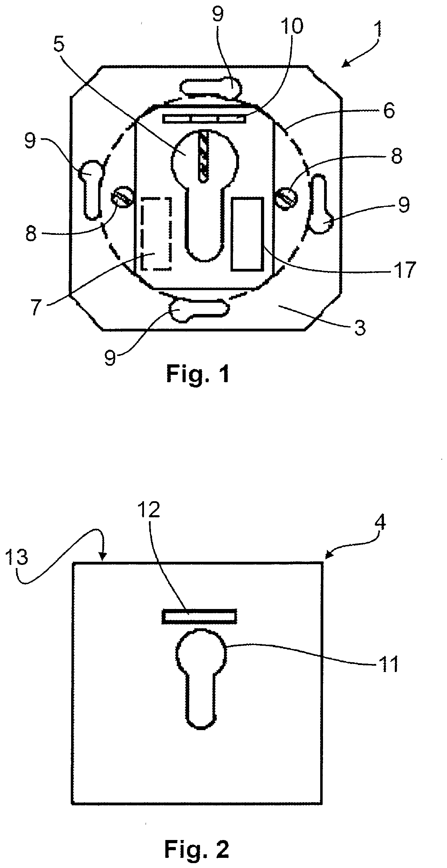

Der in den Figuren 1 bis 3 dargestellte Schlüsseltaster 1 kann z. B. zur Fluchtwegsicherung bei Türen, Toren oder Fenstern eingesetzt werden. Üblicherweise wird der Schlüsseltaster 1 im Bereich beispielsweise einer Tür, vorzugsweise unter Putz in einer Wand verbaut. Auch die strom- bzw. datenführenden Leitungen, die den Schlüsseltaster mit einer Stromquelle bzw. mit einer Leitstelle oder Zentrale verbinden sind vorzugsweise unter Putz verlegt. Natürlich kann der Schlüsseltaster auch an einer Wand als Aufputztaster montiert werden.

Der in Figur 1 dargestellte Schlüsseltaster 1 besteht aus einer Platinensteuerung 6, welche durch eine unterbrochene Linie dargestellt ist, die zur Montage in eine hier nicht dargestellte Unterputzdose passt. Die Unterputzdose und die Blende 4 des Schlüsseltasters 1, welche in Figur 2 dargestellt ist, bilden nach der Montage das Gehäuse des Schlüsseltasters 1. Der Montagerahmen 3 ist bei dem dargestellten Ausführungsbeispiel als Berührungssensor ausgestaltet, d. h., dass der Berührungssensor integral mit dem Montagerahmen 3 ausgebildet ist. Üblicherweise ist der Montagerahmen 3 und die Platinensteuerung von einer Blende 4 abgedeckt, die in Figur 2 dargestellt ist.

In dem Schlüsseltaster 1 ist ein Schließzylinder 5 angeordnet, der sowohl als Profil- als auch als Rundzylinder ausgebildet sein kann. Zusätzlich zu dem Schließzylinder 5 umfasst das der Schlüsseltaster 1 eine Platinensteuerung 6, die im Datenaustausch mit einer übergeordneten Steuerung steht. Zudem sind an der Rückseite der Platinensteuerung 6 Anschlussklemmen 7 ausgebildet, die dem Anschluss des erfindungsgemäßen Schlüsseltasters 1 an eine Stromversorgung und/oder an eine Datenleitung dienen, um beispielsweise Daten über einen DCW-Bus an eine übergeordnete Steuerung zu übermitteln, und diese mittels einer Systemsoftware welche beispielsweise unter dem Namen TMS Soft der Firma Dorma bekannt ist, zu verarbeiten.

Auf der Vorderseite der Platinensteuerung 6 ist rechts neben dem Schließzylinder 5 ein Sabotagkontakt 17 angeordnet, der mit einem nicht dargestellten Kontaktelement auf der Rückseite der Blende 4 beim Aufbringen der Blende 4 auf dem Montagerahmen in Kontakt steht und durch das Kontaktelement in Kontaktstellung gebracht wird.

Die Platinsteuerung 6 und der Montagerahmen 3 die sowohl einzeln, dass heißt ein Bauteil bildend, oder mehrteilig ausgestaltet sein können, entsprechen in ihren Abmessungen vorzugsweise den Abmessungen der Standard- Aufputz oder Unterputzsysteme, die aus Kunststoff oder Metall bestehen. Vorzugsweise wird die Platinensteuerung 6 an oder in einer Wand oder einer Montageplatte über Langlöcher 9 innerhalb des Montagerahmens 3 in oder an der Wand befestigt, vorzugsweise verschraubt. Zur Befestigung der Platinensteuerung 6 an dem Montagerahmen 3 dienen Schrauben 8. Die Schrauben 8 können auch als Dosenschrauben dienen, zum Spreizen von Krallen, die ein Verspannen des Montagerahmens 3 in einer Unter- oder Aufputzdose oder in der Wand bewirken.

Oberhalb des Schließzylinders ist auf der Platinensteuerung 6 eine LED-Anzeige 10 angeordnet, die der Statusanzeige des Berührungssensors, vorliegend dem als Berührungssensor ausgestalteten Montagerahmen 3 dient. Die LED-Anzeige 10 kann mehrere Leuchtdioden mit unterschiedlichen Farben umfassen. Die LED-Anzeige 10 kann aber auch wenigstens eine mehrfarbige Leuchtdiode umfassen, die in der Lage ist, Licht mit unterschiedlichen Farben zu emittieren.

Vorliegend umfasst die LED-Anzeige 10 eine blaue Leuchtdiode bzw. ein blaue Leuchtdiodenleiste, die die Funktion des als Berührungssensor ausgestalteten Montagerahmens 3 am Schlüsseltaster 1 anzeigt. Weitere mögliche LED Farben können gelb, rot und grün oder eine Mischung aus diesen Farben inklusive blau sein. Das Leuchten einer roten LED kann dabei die Sicherung des Fluchtwegsystems anzeigen. LED=grün kann eine Entriegelung des Fluchtwegsystems anzeigen und LED=gelb könnte einen Alarm bzw. eine Sabotagealarm anzeigen. Vorzugsweise steht die Anzeige LED blau für die Funktion "Sensor aktiv".

Figur 2 zeigt die Blende 4, die die Platinensteuerung 6 und den Montagerahmen 3 des erfindungsgemäßen Schlüsseltasters 1 abdeckt. In der Blende 4, die vorzugsweise aus Kunststoff besteht, ist ein Ausschnitt 11 in der Form des Schließzylinders 5 konturiert. Oberhalb der Ausschnitts 11 ist ein weiterer Ausschnitt 12 in Form der LED-Anzeige 10 konturiert. Natürlich kann anstelle des Ausschnitts 12 auch ein Fenster in der Blende 4 angeordnet sein. Auf den Ausschnitt 12 für die LED-Anzeige 10 könnte auch verzichtet werden, wenn das Material der Blende 4 zumindest im Bereich der LED-Anzeige 10 zumindest teilweise lichtdurchlässig ist, d. h. das Licht der LED-Anzeige 10 durch das Material der Blende sichtbar ist. Es ist auch denkbar, auf den Ausschnitt 11 zu verzichten, wenn der Berührungssensor des erfindungsgemäßen Schlüsseltasters 1, die über den Schließzylinder 5 vermittelten Funktionen ersetzen kann.

Die Blende 4 ist vorzugsweise mit deren Rückseite 13 über wenigstens ein nicht dargestelltes Kontaktelement mit Sabotagekontakt 17, der vorzugsweise auf der Vorderseite der Platinensteuerung 6 angeordnet ist, mit dem als Berührungssensor ausgestalteten Montagerahmen 3 gekoppelt.

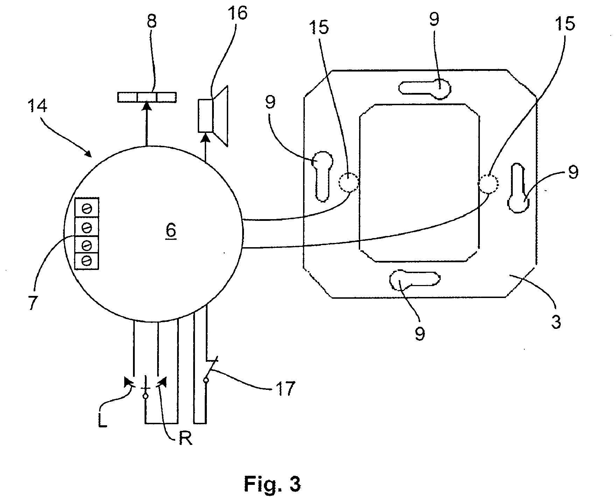

Schließlich zeigt die Figur 3 einen Schaltplan der Platinensteuerung 6 für den als Berührungssensor ausgestalteten Montagerahmen 3 des Schlüsseltasters 1. Bei der Platinensteuerung 6 bzw. dem Bauteil der Platinensteuerung 6, das den Berührungssensor schaltet bzw. den Berührungssensor mit der Platinensteuerung 6 kontaktiert, handelt es sich bevorzugt um einen Mikroschalter. In besonders bevorzugter Weise erfolgt die Auswertung des Berührungssensors mit einem speziellen Schaltkreis (IC) auf der Platinensteuerung 6.

Der Montagerahmen 3 steht über zwei Kontakte 15, die vorliegend durch unterbrochene Linien dargestellt sind, mit der Platinensteuerung 6 in Kontakt. Natürlich kann auch ein Kontakt 15 oder mehr als zwei Kontakte 15 zwischen dem Montagerahmen 3 und der Platinensteuerung 6 ausgebildet sein. Über eine Rechts- (R) oder Linkstastung (L) über den Schließzylinder 5 oder in bevorzugter Weise über die übergeordnete Steuerung kann die Funktion des Berührungssensors eingestellt werden, die über die LED-Anzeige 10 angezeigt wird. Zusätzlich zu der LED-Anzeige 10 kann über die Rechts- (R) oder Linkstastung (L) über den Schließzylinder 5 beispielsweise ein durch einen akustischen Signalgeber 16 abgegebenes Vorwarnsignal, dass eventuell fälschlicherweise aktiviert wurde, wieder deaktiviert werden. Das bedeutet, dass das Vorwarnsignal abgestellt werden kann, bevor ein Sabotagealarm gesendet wird.

Zusätzlich zu den Kontakten 15, die den als Berührungssensor ausgestalteten Montagerahmen 3 mit der Platinensteuerung 6 verbinden, kann am Montagerahmen 3 ein nicht dargestellter Sabotagekontakt ausgestaltet sein, der zwischen dem Montagerahmen 3 und der Blende 4 angeordnet ist. Wird beispielsweise die Blende 4 mechanisch vom Montagerahmen 3 gelöst, wird über den unterbrochenen bzw. zerstörten Sabotagekontakt ein Signal gesendet, welches über die Systemsoftware als Sabotagealarm visualisiert bzw. als akustisches Signal wiedergegeben wird.

### Bezugszeichenliste

- 1: Schlüsseltaster
- 3: Montagerahmen
- 4: Blende
- 5: Schließzylinder
- 6: Platinensteuerung
- 7: Anschlussklemme
- 8: Schrauben
- 9: Langlöcher
- 10: LED-Anzeige
- 11: Ausschnitt in der Blende 4 in der Kontur des Schließzylinders
- 12: Ausschnitt in der Blende 4 in der Kontur der LED-Anzeige
- 13: Rückseite der Blende 4
- 14: Schaltplan
- 15: Kontakte zwischen Montagerahmen und Platinensteuerung
- 16: akustischer Signalgeber
- R: Rechtstastung über den Schließzylinder
- L: Linkstastung über den Schließzylinder
- 17: Sabotagekontakt

## Patentansprüche

1. Schlüsseltaster (1) zur Sicherung von Türen, Toren oder Fenstern, umfassend einen Montagerahmen (3), einen Schließzylinder (5) und eine den Montagerahmen (3) abdeckende Blende (4), die zumindest an dem Montagerahmen (3) befestigbar ist, **dadurch gekennzeichnet, dass** im Bereich zwischen dem Montagerahmen (3) und der Blende (4) wenigstens ein Berührungssensor angeordnet ist, über den der Schlüsseltaster (1) betätigbar ist, wobei der Berührungssensor so sensitiv eingestellt ist, dass bereits ein Annähern an den Berührungssensor zu einer Betätigung des Schlüsseltasters (1) führt, wobei der Berührungssensor eine Kurzzeitentriegelung oder eine andere parametrierbare Funktion auslöst.

2. Schlüsseltaster (1) nach Anspruch 1, **dadurch gekennzeichnet, dass** der Berührungssensor an dem Montagerahmen (3) angeordnet ist.

3. Schlüsseltaster (1) nach Anspruch 1 oder 2, **dadurch gekennzeichnet, dass** der Berührungssensor integral mit dem Montagerahmen (3) ausgebildet ist.

4. Schlüsseltaster (1) nach einem der vorhergehenden Ansprüche, **dadurch gekennzeichnet, dass** der Berührungssensor mit der Blende (4) zusammenwirkt.

5. Schlüsseltaster (1) nach einem der vorhergehenden Ansprüche, umfassend wenigstens eine Statusanzeige.

6. Schlüsseltaster (1) nach Anspruch 5, **dadurch gekennzeichnet, dass** die Statusanzeige wenigstens ein Leuchtmittel umfasst.

7. Schlüsseltaster (1) nach Anspruch 5 oder 6, **dadurch gekennzeichnet, dass** die Statusanzeige eine LED Anzeige (10) mit wenigstens einer ein- und/oder mehrfarbigen Leuchtdiode ist.

8. Schlüsseltaster (1) nach einem der vorhergehenden Ansprüche, **dadurch gekennzeichnet, dass** wenigstens ein Sabotagekontakt mit der Blende (4) gekoppelt ist.

9. Schlüsseltaster (1) nach einem der vorhergehenden Ansprüche, **dadurch gekennzeichnet, dass** die Blende (4) wenigstens einen Ausschnitt (12) für die Statusanzeige aufweist.

10. Schlüsseltaster (1) nach einem der vorhergehenden Ansprüche, **dadurch gekennzeichnet, dass** die Blende (4) wenigstens einen Ausschnitt für einen auf einer Platinensteuerung (6) angeordneten Schließzylinder (5) aufweist.

11. Schlüsseltaster (1) nach Anspruch 5 oder 10, **dadurch gekennzeichnet, dass** der Berührungssensor Signale an die Platinensteuerung (6) zum Steuern der Statusanzeige und/oder eines Signalgebers weiterleitet.

12. Schlüsseltaster (1) nach Anspruch 10, **dadurch gekennzeichnet, dass** die Platinenteuerung (6) im Datenaustausch mit einer Tür-, Tor- oder Fenstersteuerung steht.

## Claims

1. A key-operated button (1) for securing doors, gates or windows, comprising a mounting frame (3), a locking cylinder (5) and a screen (4) covering said mounting frame (3), which screen may be fastened at least to the mounting frame (3), **characterized in that** in the area between the mounting frame (3) and the screen (4) at least one tactile sensor is disposed, by means of which the key-operated button (1) is actuatable, wherein the tactile sensor is set to be so sensitive that already approaching the tactile sensor results in an actuation of the key-operated button (1), wherein the tactile sensor triggers a short term unlocking or another parameterizable function.

2. The key-operated button (1) according to claim 1, **characterized in that** the tactile sensor is disposed at the mounting frame (3).

3. The key-operated button (1) according to claim 1 or 2, **characterized in that** the tactile sensor is configured integrally with the mounting frame (3).

4. The key-operated button (1) according to any of the preceding claims, **characterized in that** the tactile sensor cooperates with the screen (4).

5. The key-operated button (1) according to any of the preceding claims, comprising at least one status display.

6. The key-operated button (1) according to claim 5, **characterized in that** the status display comprises at least one lighting means.

7. The key-operated button (1) according to claim 5 or 6, **characterized in that** the status display is an LED-display (10) including at least one unicoloured and/or multi-coloured light emitting diode.

8. The key-operated button (1) according to any of the preceding claims, **characterized in that** at least one sabotage contact is coupled to the screen (4).

9. The key-operated button (1) according to any of the preceding claims, **characterized in that** the screen (4) includes at least one cut-out (12) for the status display.

10. The key-operated button (1) according to any of the preceding claims, **characterized in that** the screen (4) includes at least one cut-out for a locking cylinder (5), which is disposed on a printed circuit control (6).

11. The key-operated button (1) according to claim 5 or 10, **characterized in that** the tactile sensor forwards signals to the printed circuit control (6) for controlling the status display and/or a signal transmitter.

12. The key-operated button (1) according to claim 10, **characterized in that** the printed circuit control (6) is exchanging data with a door, gate or window control.

## Revendications

1. Bouton à clé (1) pour la sécurisation de portes, portails ou fenêtres, comportant un cadre de montage (3), un cylindre de fermeture (5) et un écran (4) couvrant le cadre de montage (3) lequel écran est fixable au moins sur le cadre de montage (3), **caractérisé en ce que,** dans la région entre le cadre de montage (3) et l'écran (4), au moins un détecteur tactile est agencé, par l'intermédiaire duquel le bouton à clé (1) est actionnable, le détecteur tactile étant ajusté si sensiblement que déjà une approche au détecteur tactile cause un actionnement du bouton à clé (1), le détecteur tactile déclenchant un déverrouillage de courte durée ou une autre fonction paramétrable.

2. Bouton à clé (1) selon la revendication 1, **caractérisé en ce que** le détecteur tactile est agencé sur le cadre de montage (3).

3. Bouton à clé (1) selon la revendication 1 ou 2, **caractérisé en ce que** le détecteur tactile est aménagé de façon intégrée avec le cadre de montage (3).

4. Bouton à clé (1) selon l'une des revendications précédentes, **caractérisé en ce que** le détecteur tactile coopère avec un écran (4).

5. Bouton à clé (1) selon l'une des revendications précédentes, comportant au moins un affichage d'état.

6. Bouton à clé (1) selon la revendication 5, **caractérisé en ce que** l'affichage d'état comporte au moins un moyen d'éclairage.

7. Bouton à clé (1) selon la revendication 5 ou 6, **caractérisé en ce que** l'affichage d'état consiste en un affichage à DEL (10)avec au moins une diode électroluminescente mono- et/ou multi-couleur.

8. Bouton à clé (1) selon l'une des revendications précédentes, **caractérisé en ce qu'au** moins un contact de sabotage est couplé à l'écran (4).

9. Bouton à clé (1) selon l'une des revendications précédentes, **caractérisé en ce que** l'écran (4) présente au moins une échancrure (12) pour l'affichage d'état.

10. Bouton à clé (1) selon l'une des revendications précédentes, **caractérisé en ce que** l'écran (4) présente au moins une échancrure pour un cylindre de fermeture (5) qui agencé sur la platine de contrôle (6).

11. Bouton à clé (1) selon la revendication 5 ou 10, **caractérisé en ce que** le détecteur tactile transmet des signaux vers la platine de contrôle (6) pour contrôler l'affichage d'état et/ou un émetteur de signaux.

12. Bouton à clé (1) selon la revendication 10, **caractérisé en ce que** la platine de contrôle (6) est en échange de données avec un contrôle de porte, de portail ou de fenêtre.
